# FASCICULE DE BREVET EUROPEEN

(11) **EP 3 165 059 B1**
(45) Date de publication et mention de la délivrance du brevet: **31.10.2018**
(21) Numéro de dépôt: 15742344.3
(22) Date de dépôt: 24.06.2015
(51) Int. Cl.: H05K 5/00, B60R 16/023

(54) **ENSEMBLE DE FIXATION D'UN BOITIER ELECTRONIQUE ET VEHICULE EQUIPE D'UN TEL ENSEMBLE**
BAUGRUPPE ZUR BEFESTIGUNG EINES ELEKTRONISCHEN GEHÄUSES UND MIT EINER DERARTIGEN BAUGRUPPE AUSGERÜSTETES FAHRZEUG
ASSEMBLY FOR ATTACHING AN ELECTRONIC BOX AND VEHICLE PROVIDED WITH SUCH AN ASSEMBLY

(30) Priorité: 01.07.2014 FR 1456258
(43) Date de publication de la demande: 10.05.2017
(73) Titulaire: PSA Automobiles SA, 78300 Poissy (FR)
(72) Inventeur: BAIL, Jean-bastien, F-92100 Boulogne Billancourt (FR); GOUEDARD, Olivier, F-91670 Angerville (FR)
(86) Numéro de dépôt international: PCT/FR2015/051708
(87) Numéro de publication internationale: WO 2016/001533

(56) Documents cités:
- EP-A2- 0 908 363
- EP-A2- 2 267 855
- WO-A1-2012/159813
- DE-A1-102010 034 520
- FR-A1- 2 872 379
- FR-A1- 2 997 656
- GB-A- 2 313 488

## Description

L'invention a trait au domaine de l'électronique embarqué sur les véhicules automobiles et plus particulièrement à la fixation de boîtiers électroniques sur une caisse du véhicule automobile.

Les véhicules automobiles sont pourvus de systèmes électroniques embarqués permettant, via un ordinateur de bord, une gestion des organes du véhicule et une aide au conducteur pour contrôler le véhicule plus facilement. On pourra citer par exemple, le système permettant d'empêcher le blocage des freins en cas de freinage brusque (ABS), la direction assistée, l'antipatinage des roues sur sol glissant, l'aide à la navigation (GPS) ou pour les véhicules haut de gamme, le correcteur d'assiette.

Dans le cas des véhicules à moteur diesel, la réglementation nationale et/ou continentale impose de contrôler et de limiter le rejet de polluants dans l'atmosphère. Ainsi, les véhicules diesel sont équipés d'un système de dépollution des gaz d'échappement et d'un circuit dédié au contrôle du taux de polluants rejetés dans l'atmosphère. Ces circuits dédiés comprennent généralement au moins une sonde placée sur la ligne d'échappement du véhicule, et un boîtier électronique relié d'une part à la sonde, via un câble, et d'autre part à l'ordinateur de bord du véhicule, via un faisceau électrique. A l'exemple du document WO2012159813A1, les boitiers électroniques peuvent être maintenus par un ensemble de fixation comprenant un support de boîtier électronique, le support comprenant une coque formant une réserve dans laquelle est reçu le boîtier électronique, la coque intégrant également au moins deux pattes d'encliquetage pour la retenue du boîtier électronique dans la réserve, le support comprenant, en outre, un chemin de câbles formant un canal (implicite) délimité par un fond et deux bordures latérales faisant saillie de part et d'autre du fond, le canal et la réserve communicant l'un avec l'autre.

Ces circuits dédiés sont généralement placés et fixés sous la caisse du véhicule, de sorte à être au plus prêt de la ligne d'échappement. Toutefois, le positionnement du boîtier sous la caisse du véhicule présente un risque d'endommagement du boîtier ou du câble. En effet, sous la caisse du véhicule, le boîtier peut être atteint par des projections de graviers, d'eau ou encore de boue, ces projections pouvant nuire au bon fonctionnement du boîtier et même le détruire.

Outre les projections, le boîtier électronique peut également être endommagé par des chocs. C'est particulièrement le cas pour les véhicules destinés à emprunter des chemins (ou des routes) accidenté(e)s ou sinueux(ses) tels que les véhicules utilitaires sport (traduction littérale de l'anglais de *Sport Utility Vehicle* plus connu sous son acronyme SUV) ou les véhicules tous terrains 4x4.

Afin de protéger ces boîtiers et de permettre leur fixation à la caisse du véhicule, le document FR 2 997 656 propose un ensemble pour châssis comprenant un support et un écran de protection thermique placés dans un tunnel dans lequel circule la ligne d'échappement du véhicule. Le boîtier est fixé sur le support, lui-même fixé sur l'écran thermique. Lors de la phase d'assemblage du véhicule, l'écran thermique vient recouvrir la caisse, de sorte que le boîtier électronique et le support soient placés entre la caisse du véhicule et l'écran thermique, l'écran thermique faisant à la fois barrière à la chaleur dégagée par la ligne d'échappement et aux projections.

Cet ensemble ne va cependant pas sans inconvénients.

Tout d'abord, le positionnement du boîtier électronique oblige à pourvoir le véhicule d'un écran thermique pouvant être réalisé en aluminium et/ou en feutre résiné. Cet écran thermique ajoute donc du poids au véhicule, alors que la tendance suivie par les constructeurs est à la réduction du poids des véhicules. De plus, la fabrication de l'écran peut être longue et coûteuse, notamment dans le cas d'un écran fabriqué en aluminium et en feutre résiné.

Ensuite, l'ensemble comprend deux pièces distinctes à savoir l'écran thermique et le support du boîtier. La multiplication des pièces engendre une augmentation de la durée d'assemblage d'un véhicule et peut conduire à des erreurs d'assemblage pouvant au mieux retarder la fin de l'assemblage et au pire nécessiter un remplacement de pièces, impliquant une perte de temps et un rebut évitable des pièces abîmées.

L'invention a pour but principal de répondre aux inconvénients de l'art antérieur.

Pour cela, un premier objectif est de proposer un ensemble de fixation comprenant un support pour boîtier électronique permettant de fixer le boîtier électronique sur la caisse du véhicule tout en le protégeant des éléments extérieurs.

Un deuxième objectif est de proposer un support pour boîtier électronique simple et peu coûteux de fabrication.

Un troisième objectif est de proposer un support pour boîtier électronique simple d'installation sur la caisse d'un véhicule automobile.

Un quatrième objectif est de proposer un véhicule ayant une caisse sur laquelle est fixé un support pour boîtier électronique.

A cet effet, il est proposé, en premier lieu, un ensemble de fixation d'un boîtier électronique comprenant un support du boîtier électronique, et un plan inférieur d'une caisse de véhicule automobile, le support comprenant une coque formant une réserve dans laquelle est reçu le boîtier électronique, la coque intégrant également au moins deux pattes d'encliquetage pour la retenue du boîtier électronique dans la réserve, le support comprenant, en outre, un chemin (10) de câbles formant un canal délimité par un fond, deux bordures latérales faisant saillie de part et d'autre du fond et comprenant une portion (**25**) intermédiaire et une portion (**26**) d'extrémité inclinées l'une par rapport à l'autre de sorte que le chemin (**10**) de câbles peut enjamber un longeron (**27**) solidaire du plan inférieur (3) de la caisse (**2**) du véhicule (**1**), le canal et la réserve communiquant l'un avec l'autre.

En plus de la fixation, le support permet de protéger le boîtier électronique des projections et des chocs auxquels il pourrait être soumis. Ainsi, le support permet d'éviter de pourvoir le véhicule d'un écran thermique, ce qui assure un gain de poids du véhicule engendrant une diminution de la consommation de carburant et, ainsi, une diminution du rejet de polluants dans l'atmosphère.

Diverses caractéristiques supplémentaires peuvent être prévues, seules ou en combinaison :
- le support comprend une avancée en saillie pourvue d'une fente apte à recevoir un pion solidaire de la caisse du véhicule ou un ensemble vis/écrou pour assurer un maintien du support sur la caisse du véhicule
- le support comprend une surépaisseur pourvue d'un trou taraudé apte à recevoir une vis pour solidariser le support à la caisse du véhicule ;
- le chemin de câbles comprend des crochets permettant de retenir le câble dans le chemin de câbles ;
- le support est pourvu d'une ouverture pour permettre le passage d'un faisceau reliant le boîtier électronique à un ordinateur de bord du véhicule ;
- le support comprend deux parois latérales comprenant chacune un appui sur lequel vient reposer le boîtier électronique.;
- le support comprend une paroi latérale sur laquelle au moins une partie des pattes d'encliquetage sont solidaires;

Il est proposé, en second lieu, un véhicule automobile équipé d'un boîtier électronique fixé à sa caisse par un ensemble de fixation tel que décrit précédemment.

D'autres caractéristiques et avantages de l'invention apparaîtront plus clairement et de manière concrète à la lecture de la description ci-après de modes de réalisation, laquelle est faite en référence aux dessins annexés dans lesquels :
- la figure 1 est une vue en perspective de dessus d'un véhicule automobile comprenant un support pour boîtier électronique ;
- la figure 2 est une vue de dessous du support pour boîtier électronique de la figure 1, comprenant trois médaillons de détail à échelle agrandie ;
- la figure 3 est une vue de dessous partielle de la caisse du véhicule de la figure 1, sur laquelle est fixé le support pour boîtier électronique, cette vue comprenant un médaillon de détail à échelle agrandie ;
- la figure 4 est une vue de dessous d'une variante du support pour boîtier électronique, comprenant trois médaillons de détail à échelle agrandie ;
- la figure 5 est une vue en éclaté de l'assemblage du support de boîtier électronique et d'un boîtier électronique sur la caisse du véhicule.

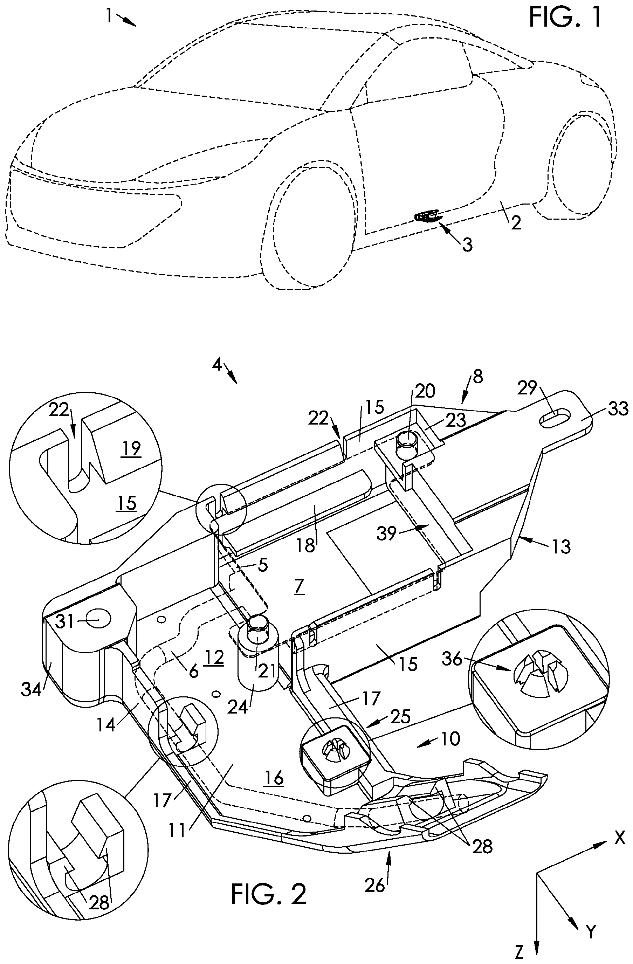

Sur la figure 1 est représenté un véhicule **1** automobile comprenant une caisse **2** ayant un plan **3** inférieur, matérialisé par une tôle, sur lequel est monté un support **4** pour boîtier **5** électronique. En l'espèce, le boîtier **5** électronique est un boîtier relié à une sonde (non représentée) par un câble **6**, et implantée dans une ligne d'échappement pour mesurer une quantité de particules polluantes circulant dans la ligne d'échappement. Le boîtier **5** électronique est pourvu d'une plaque **7** de fixation au moyen de laquelle il peut être fixé sur le support **4** comme il sera expliqué ci-après.

On définit par rapport au support **4** un repère orthogonal XYZ comprenant trois axes perpendiculaires deux à deux, à savoir :
- un axe X, définissant une direction longitudinale, horizontale,
- un axe Y, définissant une direction transversale, horizontale, qui avec l'axe X définit un plan XY horizontal,
- un axe Z, définissant une direction verticale, perpendiculaire au plan XY horizontal.

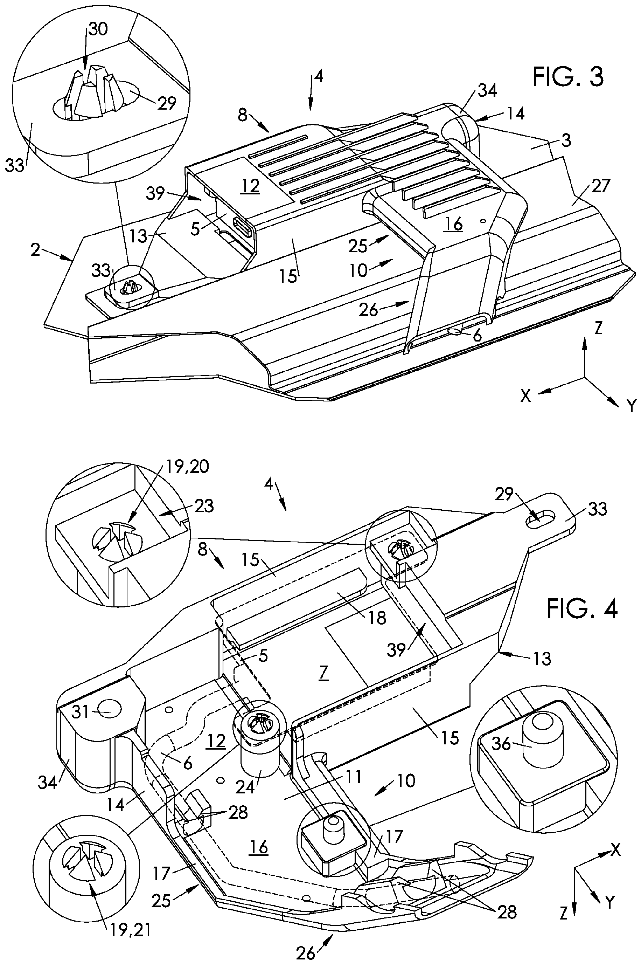

Le support **4**, particulièrement visible sur les figures 2 et 4, comprend une coque **8** formant une réserve **9** dans laquelle est reçu le boîtier **5** électronique, et un chemin **10** de câbles formant un canal **11** dans lequel est reçu le câble **6** reliant le boîtier **5** électronique à la sonde.

La réserve **9** du support **4** est délimitée par une paroi **12** de fond, une paroi **13** amont, une paroi **14** aval et deux parois **15** latérales joignant la paroi **13** amont et la paroi **14** aval. Le chemin **10** de câbles est délimité par un fond **16** et deux bordures **17** latérales faisant saillie de part et d'autre du fond **16.** L'amont et l'aval sont ici définis relativement à l'axe X, définissant la direction longitudinale, horizontale, de l'arrière vers l'avant du véhicule 1.

Comme on le voit sur les figures 2 et 4, le chemin **10** de câbles est perpendiculaire à l'une des parois **15** latérales, ladite paroi **15** latérale se terminant à la jonction avec le chemin **10** de câbles de sorte que le canal **11** soit communicant avec la réserve **9** de la coque **8**. Dans cette configuration, le chemin **10** de câbles est situé à la jonction entre la paroi **15** latérale et la paroi **14** aval de la coque **8** de sorte que la paroi **14** aval soit prolongée par l'une des bordures **17** du chemin **10** de câbles.

En variante, la paroi **15** latérale sur laquelle vient le chemin **10** de câbles est continue et seule une découpe est pratiquée dans celle-ci pour permettre le passage du câble **6** reliant le boîtier **5** électronique à la sonde.

Afin de permettre la retenue du boîtier **5** électronique dans la réserve **9**, la coque **8** est pourvue :
- de deux appuis **18** solidaire chacun de l'une des parois **15** latérales,
- d'au moins deux pattes **19** d'encliquetage, et
- de deux doigts **20**, **21** à savoir un premier doigt **20** et un deuxième doigt **21**.

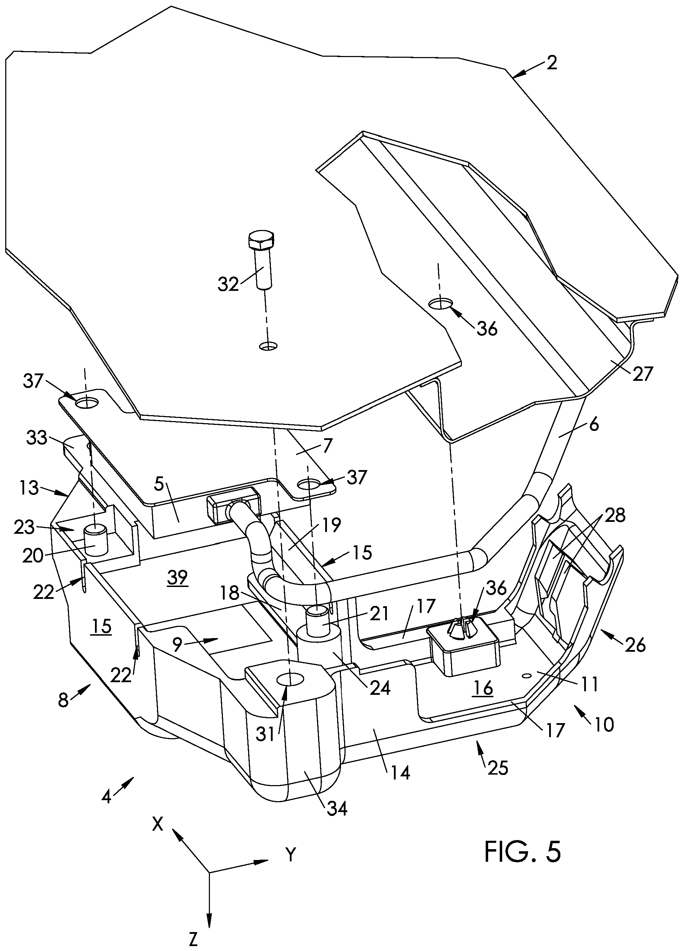

Selon un premier mode de réalisation représenté sur les figures 2 et 5, les pattes **19** d'encliquetage sont solidaires chacune d'une paroi **15** latérale. Plus précisément, en référence à l'un des détails de la figure 2, les parois **15** latérales comprennent deux découpes **22** verticales (c'est à dire suivant l'axe Z) entre lesquelles s'étend une saillie formant la patte **19** d'encliquetage. Les découpes **22** verticales permettent ainsi de créer une élasticité localisée de la paroi **15** latérale pour permettre une déformation élastique de la patte **19** d'encliquetage afin de retenir le boîtier **5** dans la réserve **9** et de le retirer si nécessaire.

Dans ce premier mode de réalisation, les doigts **20**, **21** sont situés entre les deux parois **15** latérales. Le premier doigt **20** est localisé dans un dégagement **23** aménagé entre la paroi **13** amont et l'une des parois **15** latérales. Le deuxième doigt **21** est localisé à la jonction entre la coque **8** et le chemin **10** de câbles, à proximité de la paroi **15** latérale opposée. Le deuxième doigt **21** est surélevé par rapport à la paroi **12** de fond au moyen d'un plot **24**. Ainsi, on comprend que les doigts **20**, **21** sont diagonalement opposés afin de permettre une meilleure retenue du boîtier **5** électronique.

En variante non représentée sur les dessins, les parois **15** latérales pourraient être pourvues d'un nombre supérieur de découpes **22** verticales et d'un nombre supérieur de pattes **19** d'encliquetage entre ces découpes.

Selon un deuxième mode de réalisation, représenté sur la figure 4, les pattes **19** d'encliquetage sont distinctes des parois **15** latérales de la coque **8**, les parois **15** latérales étant dépourvues de découpes **22** verticales.

Comme on le voit sur deux des détails de la figure 4, les pattes **19** d'encliquetage viennent coiffer les doigts **20**, **21**. Une découpe en forme de croix est réalisée sur les doigts **20**, **21** de sorte que chaque patte **19** d'encliquetage comprenne quatre éléments déformables élastiquement.

Dans ce deuxième mode de réalisation, les doigts **20**, **21** ont une hauteur très légèrement supérieure à l'épaisseur de la plaque **7** de fixation du boîtier **5** électronique, de sorte à limiter voire supprimer le déplacement du boîtier **5** électronique, suivant l'axe Z, entre les appuis **18** et les pattes **19** d'encliquetage.

Comme on le voit sur les figures, le chemin **10** de câbles comprend une portion **25** intermédiaire et une portion **26** d'extrémité, inclinées l'une par rapport à l'autre de sorte que le chemin **10** de câbles peut enjamber un longeron **27** solidaire de la caisse **2** du véhicule **1**, comme cela est représenté sur la figure 3, le boîtier **5** électronique étant alors disposé à côté du longeron **27**. Cette configuration du chemin **10** de câbles permet d'accroître la protection du câble **6** entre le boîtier **5** électronique et la sonde.

Comme cela est représenté sur les figures 2, 4 et 5, le chemin **10** de câbles comprend également des crochets **28** permettant de retenir le câble **6** dans le chemin **10** de câbles. Les crochets **28** sont répartis par paire dans le canal **11**, de sorte que le câble **6** soit bloqué entre deux crochets **28**. Le chemin **10** de câbles comprend deux paires de crochets **28**, à savoir une paire située dans la portion **25** intermédiaire et une paire dans la portion **26** d'extrémité.

Afin de permettre la fixation et le maintien du support **4** sur la caisse **2** du véhicule **1** automobile, le support **4** comprend :
- une fente **29** dans laquelle vient se clipser un pion **30** solidaire du plan **3** inférieur de la caisse **2** ou un ensemble vis/écrou, et
- un trou **31** taraudé apte à recevoir une vis **32**.

Plus précisément, la paroi **13** amont du support **4** comprend une avancée **33** s'étendant dans le plan XY horizontal, la fente **29** étant pratiquée dans cette avancée **33**.

Le trou **31** taraudé est, quant à lui, réalisé dans une surépaisseur **34** formée sur la paroi **14** aval de la coque **8**, le trou **31** taraudé s'étendant selon une direction sensiblement verticale, c'est à dire suivant l'axe Z.

Le support **4** est pourvu, d'un pion **36** faisant saillie du fond **16** du chemin **10** de câbles, à proximité d'une bordure **17** de celui-ci. Ce pion **36** étant apte à venir se loger dans un perçage **38** réalisé sur le longeron **27** de la caisse **2** du véhicule, pour assurer le maintien du support **4** sur la caisse **2**.

Selon un mode de réalisation représenté en figures 2 et 5, le pion **36** est encliqueté dans le perçage **38** et présente une forme analogue à celle des doigts **20**, **21** à pattes **19** d'encliquetage décrits précédemment.

Selon le deuxième mode de réalisation représenté en figure 4, le pion **36** est dépourvu de pattes d'encliquetage et vient se loger dans le perçage **38** pour assurer le positionnement du support **4** sur la caisse **2**.

Enfin, le support **4** comprend, une ouverture **39** pratiquée dans la paroi **13** amont pour permettre le passage d'un faisceau reliant le boîtier **5** électronique à un ordinateur de bord du véhicule **1** pour permettre un échange d'informations entre le boîtier **5** électronique et l'ordinateur de bord ainsi qu'une alimentation en énergie du boîtier **5** électronique.

Avantageusement, le support **4** peut être réalisé dans un matériau métallique léger comme l'aluminium ou un matériau composite, ces matériaux offrant une bonne résistance aux chocs et à la corrosion et présentant un faible poids.

Lors de l'assemblage du véhicule **1**, un opérateur assemble le boîtier **5** électronique et le câble **6** avec le support **4** de sorte que :
- le boîtier **5** électronique repose sur les appuis **18** du support **4** ;
- chaque doigt **20**, **21** du support **4** est logé dans un orifice **37** de la plaque **7** du boîtier **5** électronique ;
- les pattes **19** d'encliquetage viennent en prise avec la plaque **7** de fixation du boîtier **5** électronique ;
- le câble **6** est maintenu par les crochets **28** du chemin **10** de câbles.

Lorsque le boîtier **5** électronique et le support **4** sont solidaires l'un de l'autre, l'opérateur vient positionner le support **4** sur la caisse **2** du véhicule **1** de manière à ce que :
- le doigt **36** du chemin **10** de câbles vienne se loger dans le perçage **38** du longeron **27** de la caisse **2** ;
- la fente **29** de l'avancée **33** du support **4** accueille le pion **30** solidaire de la caisse **2** ou la vis sur laquelle un écrou viendra en prise hélicoïdale.

Une fois le support **4** positionné, l'opérateur n'a plus qu'à le solidariser avec la caisse **2** au moyen de la vis **32** traversant le plan **3** inférieur de la caisse **2** pour venir en prise hélicoïdale dans le trou **31** taraudé du support **4**.

Avantageusement, le support **4** est monobloc. Toutefois, le support **4** pourrait être composé d'une coque **8** et d'un chemin **10** de câbles distincts l'un de l'autre et assemblés par collage, rivetage, soudage ou boulonnage, par exemple.

Le support **4** qui vient d'être décrit présente de nombreux avantages.

Premièrement, le support **4** permet de maintenir le boîtier **5** électronique et de le protéger contre les projections ou les chocs, sans nécessiter l'ajout d'un écran thermique ou d'un bouclier assurant seulement la protection du boîtier **5** électronique.

Deuxièmement, le support **4** est simple et peu coûteux de fabrication. En effet, l'utilisation d'aluminium ou de matériaux composites permet, outre les qualités de résistance et de légèreté déjà citées, de réaliser simplement le support, par exemple par moulage. Ces matières et ce mode de fabrication offrent également l'avantage de pouvoir réaliser une fabrication en grande série assurant un faible coût de production.

Enfin, le support **4** est simple d'utilisation, étant facilement intégrable sur la caisse **2** par clipsage et facilement maintenu sur la caisse **2** au moyen d'une unique vis **32.**

## Revendications

1. Ensemble de fixation d'un boîtier (**5**) électronique comprenant un support (**4**) du boîtier (**5**) électronique, et un plan (**3**) inférieur d'une caisse (**2**) de véhicule (**1**) automobile, le support (**4**) comprenant une coque (**8**) formant une réserve (**9**) dans laquelle est reçu le boîtier (**5**) électronique, la coque (**8**) intégrant également au moins deux pattes (**19**) d'encliquetage pour la retenue du boîtier (**5**) électronique dans la réserve (**9**), le support (**4**) comprenant, en outre, un chemin (**10**) de câbles formant un canal (**11**) délimité par un fond (**16**), deux bordures (**17**) latérales faisant saillie de part et d'autre du fond (**16**), et comprenant une portion (**25**) intermédiaire et une portion (**26**) d'extrémité inclinées l'une par rapport à l'autre de sorte que le chemin (**10**) de câbles peut enjamber un longeron (**27**) solidaire du plan inférieur (3) de la caisse (**2**) du véhicule (**1**), le canal (**11**) et la réserve (**9**) communiquant l'un avec l'autre.

2. Ensemble selon la revendication 1 **caractérisé en ce que** le support (**4**) comprend une avancée (**33**) en saillie pourvue d'une fente (**29**) apte à recevoir un pion (**30**) solidaire de la caisse (**2**) du véhicule (**1**) ou un ensemble vis/écrou pour assurer un maintien du support (**4**) sur la caisse (**2**) du véhicule (**1**).

3. Ensemble selon l'une quelconque des revendications précédentes **caractérisé en ce que** le support (**4**) comprend une surépaisseur (**34**) pourvue d'un trou (**31**) taraudé apte à recevoir une vis (**32**) pour solidariser le support (**4**) à la caisse du véhicule (**1**).

4. Ensemble selon l'une quelconque des revendications précédentes **caractérisé en ce que** le chemin (**10**) de câbles comprend des crochets (**28**) permettant de retenir un câble (**6**) dans le chemin (**10**) de câbles.

5. Ensemble selon l'une quelconque des revendications précédentes **caractérisé en ce que** le support (**4**) est pourvu d'une ouverture (**39**) pour permettre le passage d'un faisceau reliant le boîtier (**5**) électronique à un ordinateur de bord du véhicule (**1**).

6. Ensemble selon l'une quelconque des revendications précédentes **caractérisé en ce que** le support (**4**) comprend deux parois (**15**) latérales comprenant chacune un appui (**18**) sur lequel vient reposer le boîtier (**5**) électronique.

7. Ensemble selon l'une quelconque des revendications précédentes **caractérisé en ce que** le support (**4**) comprend une paroi (**15**) latérale sur laquelle au moins une partie des pattes (**19**) d'encliquetage sont solidaires.

8. Véhicule (**1**) automobile équipé d'un boîtier électronique fixé à sa caisse par un ensemble de fixation selon l'une quelconque des revendications précédentes,

## Patentansprüche

1. Baugruppe zur Befestigung eines elektronischen Gehäuses (5), die einen Träger (4) des elektronischen Gehäuses (5) und eine untere Ebene (3) einer Karosserie (2) eines Kraftfahrzeugs (1) umfasst, wobei der Träger (4) eine Schale (8) umfasst, die eine Kammer (9) bildet, in der das elektronische Gehäuse (5) aufgenommen ist, wobei die Schale (8) auch mindestens zwei Einrastpratzen (19) für das Zurückhalten des elektronischen Gehäuses (5) in der Kammer (9) integriert, wobei der Träger (4) außerdem einen Kabeltrog (10) umfasst, der einen Kanal (11) bildet, der von einem Boden (16), zwei seitlichen Ränder (17), die zu jeder Seite des Bodens (16) vorragen, abgegrenzt ist, und die einen Zwischenabschnitt (25) und einen Endabschnitt (26) umfassen, die zueinander derart geneigt sind, dass der Kabeltrog (10) einen Längsträger (27), der fest mit der unteren Ebene (3) der Karosserie (2) des Fahrzeugs (1) verbunden ist, überspannen kann, wobei der Kanal (11) und die Kammer (9) miteinander in Verbindung stehen.

2. Baugruppe nach Anspruch 1, **dadurch gekennzeichnet, dass** der Träger (4) einen vorragenden Vorsprung (33) umfasst, der mit einem Schlitz (29) versehen ist, der geeignet ist, um einen Stift (30), der fest mit der Karosserie (2) des Fahrzeugs (1) verbunden ist, oder eine Einheit aus Schraube/Mutter aufzunehmen, um das Halten des Trägers (4) auf der Karosserie (2) des Fahrzeugs (1) sicherzustellen.

3. Baugruppe nach einem der vorhergehenden Ansprüche, **dadurch gekennzeichnet, dass** der Träger (4) eine Überdicke (34) umfasst, die mit einem Innengewindeloch (31) versehen ist, das geeignet ist, eine Schraube (32) zum festen Verbinden des Trägers (4) mit der Karosserie des Fahrzeugs (1) aufzunehmen.

4. Baugruppe nach einem der vorhergehenden Ansprüche, **dadurch gekennzeichnet, dass** der Kabeltrog (10) Haken (28) umfasst, die es erlauben, ein Kabel (6) in dem Kabeltrog (10) zurückzuhalten.

5. Baugruppe nach einem der vorhergehenden Ansprüche, **dadurch gekennzeichnet, dass** der Träger (4) mit einer Öffnung (39) versehen ist, um das Durchgehen eines Bündels, das das elektronische Gehäuse (5) mit einem Bordrechner des Fahrzeugs (1) verbindet, zu erlauben.

6. Baugruppe nach einem der vorhergehenden Ansprüche, **dadurch gekennzeichnet, dass** der Träger (4) zwei Seitenwände (15) umfasst, die jeweils eine Auflage (18) umfassen, auf der das elektronische Gehäuse (5) zum Ruhen kommt.

7. Baugruppe nach einem der vorhergehenden Ansprüche, **dadurch gekennzeichnet, dass** der Träger (4) eine Seitenwand (15) umfasst, auf der mindestens ein Teil der Einrastpratzen (19) fest verbunden ist.

8. Kraftfahrzeug (1), das mit einem elektronischen Gehäuse ausgestattet ist, das an seiner Karosserie durch eine Befestigungsbaugruppe nach einem der vorhergehenden Ansprüche befestigt ist.

## Claims

1. An assembly for attaching an electronic box (5) including a mounting (4) of the electronic box (5), and a lower plane (3) of a body (2) of a motor vehicle (1), the mounting (4) including a shell (8) forming a storage space (9) in which the electronic box (5) is received, the body shell (8) also integrating at least two snap-fastening tabs (19) for retaining the electronic body (5) in the storage space (9), the mounting (4) further including a cable run (10) forming a channel (11) delimited by a bottom (16), two side edges (17) projecting on either side of the bottom (16), and including an intermediate portion (25) and an end portion (26) which are inclined with respect to one another such that the cable run (10) can span a longitudinal member (27) integral with the lower plane (3) of the body (2) of the vehicle (1), the channel (11) and the storage space (9) communicating with one another.

2. The assembly according to Claim 1, **characterized in that** the mounting (4) includes a projecting overhang (33) provided with a slot (29) able to receive a pin (30) integral with the body (2) of the vehicle (1) or a screw/nut assembly to ensure a maintaining of the mounting (4) on the body (2) of the vehicle (1).

3. The assembly according to any one of the preceding claims, **characterized in that** the mounting (4) includes an overthickness (34) provided with a tapped hole (31) able to receive a screw (32) for securing the mounting (4) to the body of the vehicle (1).

4. The assembly according to any one of the preceding claims, **characterized in that** the cable run (10) includes hooks (28) permitting a cable (6) to be retained in the cable run (10).

5. The assembly according to any one of the preceding claims, **characterized in that** the mounting (4) is provided with an opening (39) to permit the passage of a bundle connecting the electronic box (5) to an on-board computer of the vehicle (1).

6. The assembly according to any one of the preceding claims, **characterized in that** the mounting (4) includes two lateral walls (15) each including a support (18) on which the electronic box (5) comes to rest.

7. The assembly according to any one of the preceding claims, **characterized in that** the mounting (4) includes a lateral wall (15) on which at least a portion of the snap-fastening tabs (19) are integral.

8. A motor vehicle (1) equipped with an electronic box fixed to its body by an attachment assembly according to any one of the preceding claims.
